Europäisches Patentamt

European Patent Office

Office européen des brevets

(11) Veröffentlichungsnummer: **0 318 651**
A2

(12) **EUROPÄISCHE PATENTANMELDUNG**

(21) Anmeldenummer: **88114874.6**

(22) Anmeldetag: **12.09.88**

(51) Int. Cl.⁴: **H01L 39/24**

(30) Priorität: **28.11.87 DE 3740467**

(43) Veröffentlichungstag der Anmeldung:
**07.06.89 Patentblatt 89/23**

(84) Benannte Vertragsstaaten:
**CH FR GB IT LI SE**

(71) Anmelder: **Kernforschungszentrum Karlsruhe GmbH**
**Weberstrasse 5 Postfach 3640**
**D-7500 Karlsruhe 1(DE)**

(72) Erfinder: **Dietrich, Manfred, Dr.**
**Trierer Strasse 33**
**D-7500 Karlsruhe(DE)**
Erfinder: **Geerk, Jochen, Dr.**
**Nibelungenring 57**
**D-7513 Stutensee 1(DE)**

(54) **Flexibler Supraleiter.**

(57) Die Erfindung betrifft einen flexiblen Supraleiter, bestehend aus mindestens einer Trägerfaser, deren Mantelfläche von einer supraleitenden Schicht umhüllt ist und ein Verfahren zu dessen Herstellung.

Die Aufgabe der Erfindung besteht in der Bereitstellung von Hoch-$T_c$-Supraleitern hoher Stromdichte in Form technisch anwendbarer Filamentfasern.

Die Aufgabe wird erfindungsgemäß gelöst durch eine Trägerfaser aus Siliciumcarbid (SiC), die von einer oxidischen, supraleitenden Keramik umhüllt ist, wobei die Umhüllung durch die bekannten Methoden der Dünnschichttechnik, vorzugsweise durch Kathodenzerstäubungstechniken, auf der Trägerfaser erzeugt wird.

EP 0 318 651 A2

### Flexibler Supraleiter

Die Erfindung betrifft einen flexiblen Supraleiter, bestehend aus mindestens einer Trägerfaser, deren Mantelfläche von einer supraleitenden Schicht umhüllt ist und ein Verfahren zur Herstellung flexibler Supraleiter.

Einige oxidische Keramiken (die sogenannten Perowskite) weisen besonders hohe Sprungtemperaturen auf und sind deshalb noch bei vergleichsweise hohen Temperaturen supraleitend.

Ein Beispiel für eine solche oxidische, supraleitende Keramik ist $YBa_2Cu_3O_7$. Weitere supraleitende Keramiken können davon abgeleitet werden, indem z. B. Yttrium durch andere Seltene Erden oder z. B. Kupfer durch andere Metallatome ersetzt wird.

Diese Perowskite sind jedoch sehr spröde, so daß mit den üblichen Methoden aus diesem Material keine supraleitenden Fasern erzeugt werden können.

Aus der DE-PS 28 56 885 ist ein Verfahren zur Herstellung eines flexiblen Supraleiters, bestehend aus einer C-Faser mit einer dünnen Schicht einer Niobverbindung der allgemeinen Formel $NbC_xN_y$ bekannt.

Aus der DE-PS 32 49 624 ist ein Verfahren zur Beschichtung von Kohlenstoff-, Bor- und Stahlfasern mit Niobverbindungen der allgemeinen Formel $NbC_xN_yO_z$ durch reaktive Kathodenzerstäubung bekannt.

Die Supraleiter, die nach diesen Verfahren hergestellt wurden, weisen jedoch eine gegenüber den oxidischen Keramiken wesentlich tiefere Springtemperatur auf.

Die Beschichtung der genannten Trägerfasern mit den Niobverbindungen ist deshalb möglich, weil diese Beschichtung in inerter Gasatmosphäre durchgeführt werden kann.

Die Herstellung einer Schicht einer oxidischen Keramik erfordert Temperaturen von etwa 800° C und die Gegenwart von gasförmigem Sauerstoff. Unter derart aggressiven Bedingungen ist keine der genannten Trägerfasern beständig.

Aus DE-PS 33 19 524 ist bekannt, daß die Mantelfläche der Trägerfaser mit einem Carbid, z. B. mit SiC, abgedeckt werden kann, auf der die supraleitende Schicht haftet. Diese Deckschicht kann jedoch nicht verhindern, daß bei hohen Temperaturen und bei Anwesenheit von Sauerstoff der Kern schmilzt oder chemisch ungewandelt wird oder daß Sauerstoff durch diese Deckschicht diffundiert und den Kern schädigt. Damit ist auch die Haftung dieser Deckschicht nicht mehr gewährleistet.

Der Erfindung liegt die Aufgabe zugrunde, flexible Hoch-$T_c$-Supraleiter hoher Stromdichte in Form technisch anwendbarer Filamentfasern anzugeben.

Der Erfindung liegt die weitere Aufgabe zugrunde, ein Verfahren zur Herstellung solcher Supraleiter zu schaffen.

Die Aufgabenstellung erfordert insbesondere, daß ein Trägerfaser-Material gefunden wird, das unter den aggressiven Bedingungen, die zur Beschichtung der Trägerfasern mit oxidischer Keramik erforderlich sind, nämlich bei Gegenwart von Sauerstoff und Temperaturen über 800° C, nicht geschädigt wird.

Weiterhin ist erforderlich, daß die physikalischen Eigenschaften, z. B. thermische Ausdehnung des Trägerfaser-Materials und der oxidischen Keramik, ähnlich sind und daß die supraleitende Keramik auf der Trägerfaser haftet.

Die Aufgabe wird erfindungsgemäß gelöst durch einen flexiblen Supraleiter, bestehend aus mindestens einer Trägerfaser, deren Mantelfläche von einer supraleitenden Schicht umhüllt ist, der dadurch gekennzeichnet ist, daß die Trägerfaser aus Siliciumcarbid (SiC) und die supraleitende Schicht aus einer oxidischen Keramik bestehen und daß die oxidische Keramik durch die bekannten Methoden der Dünnschichttechnik, vorzugsweise durch Kathodenzerstäubungstechniken, auf der Trägerfaser erzeugt wurde.

Die Aufgabe, ein Verfahren zur Herstellung solcher flexibler Supraleiter zu schaffen, wird dadurch gelöst, daß

a) durch die bekannten Methoden der Dünnschichttechnik, vorzugsweise durch Kathodenzerstäubung (Sputtern), aus den Komponenten der oxidischen Keramik auf mindestens einer Trägerfaser aus SiC eine supraleitende Hülle aus oxidischer Keramik erzeugt wird,

b) die umhüllte Trägerfaser einer Oxidationsglühung in reiner Sauerstoffatmosphäre bei Temperaturen zwischen 350 und 500° C, vorzugsweise bei 430° C, unterzogen wird,

c) die auf diese Weise supraleitend beschichtete(n) Trägerfaser(n) mit Kupfer, Aluminium oder einem anderen geeigneten Stabilisierungsmaterial überzogen und anschließend in bekannter Weise zu einem Faserbündel vereinigt werden.

Eine bevorzugte Ausführungsform der Erfindung besteht in der Vorbeschichtung der Faser mit einem Perowskit, z. B. mit $SrTiO_3$. Es hat sich gezeigt, daß diese Schicht eine positive Wirkung auf die Supraleiterschicht aufweist, möglicherweise weil in ihr die Kristallstruktur des Supraleiters schon vorgebildet ist.

Wesentliche Voraussetzung für die supraleitend beschichteten Trägerfasern und deren Herstellung ist, daß die Trägerfaser während der Beschichtung nicht geschädigt wird. Die bisher bekannten Trägerfasern sind unter den Beschichtungsbedingungen nicht beständig. Diese Beschichtungsbedingungen sind so aggressiv, daß auch SiC oberflächlich angegriffen wird. Allerdings wurde beobachtet, daß sich hierbei auf der Oberfläche eine dichte Schicht aus Siliciumdioxid bildet, die einen weiteren Angriff verhindert. Dieses Siliciumdioxid wirkt sich weiterhin vorteilhaft auf die Haftung der Perowskit-Schicht aus.

Die Herstellung von $YBa_2Cu_3O_7$ gelang durch Hochleistungskathodenzerstäubung (Magnetronsputtern), wobei eine Kathode aus gesintertem $YBa_2Cu_3O_7$ verwendet wurde. Die Substrattemperatur bei der Abscheidung betrug 800° C. Die dabei entstehende tetragonale Phase wird in situ einer anschließenden Wärmebehandlung bei 430° C in $O_2$-Atmosphäre bei 1 bar ausgesetzt. Dabei bildet sich die gewünschte orthorhombische Phase mit $P_{mmm}$-Struktur und dem gewünschten Sauerstoffanteil. Die sich ergebende Einsatztemperatur zur Supraleitung auf dem Faserleiter beträgt 85 K. Verbesserungen vor allem hinsichtlich des Stromtragfähigkeit werden durch die vorherige Beschichtung der Substratfaser mit $SrTiO_3$ erzielt.

Die Erfindung wird im folgenden anhand eines Beispiels näher erläutert.

Zur Ablagerung von dünnen Filmschichten wurde ein einfacher, aber nicht kommerziell erhältlicher Hochleistungskathodenzerstäuber (Magnetron sputtering device) des planaren Typs verwendet, der in einem UHV-System aufgebaut war. Das UHV-System wurde durch eine Turbomolekularpumpe evakuiert. Eine Kathodenscheibe aus $Y_1Ba_2Cu_3O_7$ mit einem Durchmesser von 40 mm und eine Dicke von 8 mm wurde durch Sintern der entsprechenden Menge von $Y_2O_3$, $BaCO_3$ und $CuO$ in Pulverform bei hoher Temperatur und hohem Druck hergestellt.

Mit einem CoSm-Magneten an der Spitze der Kathode wurde ein Plasma-Ring mit 25 mm Durchmesser geschaffen. Das Zerstäubungsgas bestand aus einer Mischung von Sauerstoff ($2 \times 10^{-4}$ bar) und Argon ($4 \times 10^{-4}$ bar). Die Entladung vollzog sich bei 100 Volt und 0,5 A.

Ein aufgefächertes Bündel aus 1200 SiC-Fasern wurde im Abstand von 20 mm zur Kathode auf einem Heizband befestigt. Während der Abscheidung der Schicht wurden die Fasern auf 800° C erhitzt. Die Dauer der Abscheidung betrug 1 Stunde, die sich ergebende Supraleiterschichtdicke 1 μm.

Danach wurden die beschichteten Fasern 30 Minuten lang in einer Sauerstoffatmosphäre von 1 bar bei 430° C wärmebehandelt.

## Ansprüche

1. Flexibler Supraleiter, bestehend aus mindestens einer Trägerfaser, deren Mantelfläche von einer supraleitenden Schicht umhüllt ist, dadurch gekennzeichnet, daß die Trägerfaser aus Siliciumcarbid (SiC) und die supraleitende Schicht aus einer oxidischen Keramik bestehen und daß die oxidische Keramik durch die bekannten Methoden der Dünnschichttechnik, vorzugsweise durch Kathodenzerstäubungstechniken, auf der Trägerfaser erzeugt wurde.

2. Supraleiter nach Anspruch 1, dadurch gekennzeichnet, daß die Trägerfaser aus SiC mit einem Perowskit der allgemeinen Formel $ABO_3$, vorzugsweise mit Erdalkali-Titan-Oxiden, vorbeschichtet ist.

3. Verfahren zur Herstellung flexibler Supraleiter nach Anspruch 1, dadurch gekennzeichnet, daß

a) durch die bekannten Methoden der Dünnschichttechnik, vorzugsweise durch Kathodenzerstäubung (Sputtern), aus den Komponenten der oxidischen Keramik auf mindestens einer Trägerfaser aus SiC eine supraleitende Hülle aus oxidischer Keramik erzeugt wird,

b) die umhüllte Trägerfaser einer Oxidationsglühung in einer Sauerstoffatmosphäre bei Temperaturen zwischen 350 und 500° C, vorzugsweise bei 430° C, unterzogen wird,

c) · die auf diese Weise supraleitend beschichtete(n) Trägerfaser(n) mit Kupfer, Aluminium oder einem anderen geeigneten Stabilisierungsmaterial überzogen und anschließend in bekannter Weise zu einem Faserbündel vereinigt werden.

4. Verfahren nach Anspruch 3, dadurch gekennzeichnet, daß die Trägerfaser aus SiC vor Durchführung des Schrittes a) mit einem Perowskit der Formel $ABO_3$, vorzugsweise mit Erdalkali-Titan-Oxiden beschichtet wird.